# EUROPEAN PATENT APPLICATION

(11) **EP 4 417 310 A1**
(43) Date of publication of application: **21.08.2024**
(21) Application number: 22881138.6
(22) Date of filing: 02.03.2022
(51) Int. Cl.: B01J 37/08, B01J 37/00, B01J 37/04, B01J 35/00, B01J 21/06, B01J 23/75, C01B 32/162, C23C 16/442

(54) **CATALYST FOR PRODUCING CARBON NANOTUBE AND METHOD FOR PRODUCING CARBON NANOTUBE**

(30) Priority: 12.10.2021 KR 20210135298
(71) Applicant: Korea Kumho Petrochemical Co., Ltd., Seoul 04542 (KR)
(72) Inventor: JEONG, Chung Heon, Daejeon 34061 (KR); RYU, Sang Hyo, Seoul 04720 (KR); KIM, Hyun Tae, Seoul 04369 (KR); LEE, Wan Sung, Daejeon 34048 (KR); JEONG, Myung Hoon, Chungcheongbuk-do 28630 (KR); JUNG, Woo Ram, Daejeon 34049 (KR)
(74) Representative: Beck & Rössig European Patent Attorneys
(86) International application number: PCT/KR2022/002895
(87) International publication number: WO 2023/063506

(57) **Abstract**

One embodiment of the present disclosure provides a method of preparing a catalyst for manufacturing carbon nanotubes, which includes: (a) dissolving a metal precursor in a solvent to prepare a precursor solution; (b) thermally decomposing the precursor solution by spraying the precursor solution into a reactor; and (c) obtaining a catalyst, wherein the catalyst includes a metal component represented by the following Chemical Formula 1:

[Chemical Formula 1] Coₓ:[M1, Zr]_{y}:M2_{z}

wherein Co represents cobalt or oxides or derivatives thereof, M1 represents at least one metal, or oxides or derivatives thereof, selected from Al, Ca, Si, Ti, and Mg, Zr represents zirconium, or oxides or derivatives thereof, M2 represents at least one metal, or oxides or derivatives thereof, selected from W, V, Mn, and Mo, x/y satisfies 0.2 ≤ x/y ≤ 2.6, and x/z satisfies 6 ≤ x/z ≤ 13.

## Description

### Technical Field

The present disclosure relates to a catalyst for manufacturing carbon nanotubes and a method of manufacturing carbon nanotubes.

### Background Art

As the interest in and importance of eco-friendly energy and electric vehicles increases, demand for secondary batteries is rapidly increasing. High-capacity secondary batteries for electric vehicles are required to have high energy density, a long lifespan, and a low self-discharge rate. To secure these properties, it is essential to develop conductive materials having high electrical conductivity. The conductive material acts as a passage for the movement of charges within the battery. In this case, carbon-based conductive materials, for example, graphite, carbon black, graphene, carbon nanotubes, and the like, may be used as the conductive material. Conductive carbon black was mainly used in the art.

As a carbon nanotube is a material having a tubular structure composed of a hexagonal honeycomb-shaped lattice in which one carbon atom is bonded to three other carbon atoms, it has attracted attention as a next-generation conductive material for secondary batteries due to its excellent electrical conductivity. When carbon nanotubes are used as a conductive material, the energy density and lifespan of secondary batteries can be improved, and the size of the battery can be reduced. However, conventional carbon nanotubes have poor solubility and poor dispersibility in solvents, thereby making it difficult to use the carbon nanotubes as conductive materials for secondary batteries.

To solve these problems, various attempts have been made, such as physical post-processing using ball mills, pin crushers, and the like, but new problems such as work difficulties and increased costs are arising accordingly. Also, catalysts for manufacturing carbon nanotubes having various combinations of metal components and physical properties have been developed, but it is difficult to achieve dispersibility suitable as conductive materials for high-capacity secondary batteries. Therefore, there is a need for the development of carbon nanotubes, which may be used as conductive materials for secondary batteries due to excellent electrical conductivity and dispersibility, and a catalyst for manufacturing the same.

### Disclosure

### Technical Problem

The present disclosure is designed to solve the above-described problems of the related art, and thus it is an object of the present disclosure to provide a method of preparing a catalyst for manufacturing carbon nanotubes in order to manufacture carbon nanotubes having excellent electrical conductivity and dispersibility.

It is another object of the present disclosure to provide a method of manufacturing carbon nanotubes for secondary battery conductive materials having excellent electrical conductivity and dispersibility.

### Technical Solution

According to one aspect of the present disclosure, there is provided a method of preparing a catalyst for manufacturing carbon nanotubes, which includes: (a) dissolving a metal precursor in a solvent to prepare a precursor solution; (b) thermally decomposing the precursor solution by spraying the precursor solution into a reactor; and (c) obtaining a catalyst, wherein the catalyst includes a metal component represented by the following Chemical Formula 1:

[Chemical Formula 1] Coₓ:[M1, Zr]_{y}:M2_{z}

wherein Co represents cobalt or oxides or derivatives thereof, M1 represents at least one metal, or oxides or derivatives thereof, selected from Al, Ca, Si, Ti, and Mg, Zr represents zirconium, or oxides or derivatives thereof, M2 represents at least one metal, or oxides or derivatives thereof, selected from W, V, Mn, and Mo, x/y satisfies 0.2 ≤ x/y ≤ 2.6, and x/z satisfies 6 ≤ x/z ≤ 13.

According to one embodiment, step (a) may include: (a1) dissolving a Co precursor, a Zr precursor, and at least one metal precursor selected from Al, Ca, Si, Ti, and Mg in a solvent to prepare a first precursor solution; and (a2) introducing at least one metal precursor selected from W, V, Mn, and Mo to the first precursor solution to prepare a second precursor solution.

According to one embodiment, in step (a2), the first precursor solution may have a temperature of less than 30°C.

According to one embodiment, step (a2) may include: introducing the metal precursor and then stirring the resulting mixture under a nitrogen atmosphere.

According to one embodiment, step (b) may include: (b1) spraying the precursor solution into the reactor with air at 1 to 3 bar; and (b2) thermally decomposing the sprayed precursor solution at 600 to 1,000°C.

According to one embodiment, in the above chemical formula, x/y may satisfy 0.5 ≤ x/y ≤ 2.0, and x/z may satisfy 8 ≤ x/z ≤ 9.

According to another aspect of the present disclosure, there is provided a method of manufacturing carbon nanotubes, which includes: (1) introducing the catalyst for manufacturing carbon nanotubes prepared according to the method into a chemical vapor deposition reactor; and (2) spraying a carbon-based gas and a carrier gas to synthesize carbon nanotubes.

According to one embodiment, the chemical vapor deposition reactor may be a fluidized-bed chemical vapor deposition reactor.

According to one embodiment, the chemical vapor deposition reactor may have an internal temperature of 600 to 1,000°C.

According to one embodiment, the carbon-based gas may be one selected from the group consisting of saturated or unsaturated hydrocarbons having 1 to 4 carbon atoms, carbon monoxide, benzene, and a mixture of two or more thereof.

According to one embodiment, the carrier gas may be one selected from the group consisting of helium, nitrogen, argon, and a mixture of two or more thereof.

### Advantageous Effects

A catalyst for manufacturing carbon nanotubes prepared according to one aspect of the present disclosure can be applied to the synthesis of carbon nanotubes having excellent electrical conductivity and dispersibility.

Also, carbon nanotubes manufactured according to another aspect of the present disclosure have excellent physical properties, including electrical conductivity and dispersibility, and thus can improve the capacity and lifespan characteristics of secondary batteries when used as a conductive material for secondary batteries.

However, it should be understood that the effect of one aspect of the present disclosure is not limited to the above-described effects, but is intended to encompass all effects deducible from the configuration described in the detailed description of the present disclosure or in the claims.

### Description of Drawings

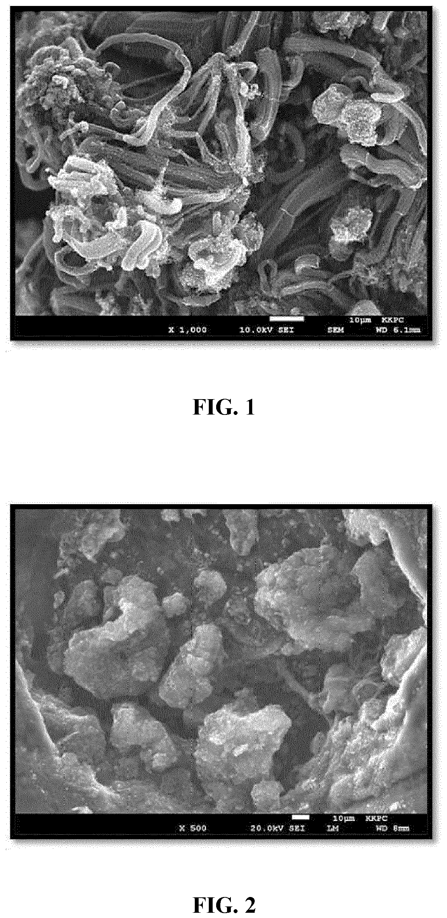

FIGS. 1 and 2 are FE-SEM images of carbon nanotubes manufactured using a catalyst for manufacturing carbon nanotubes according to one embodiment of the present disclosure.

### Best Mode

Hereinafter, one aspect of the present disclosure will be described with reference to the accompanying drawings. However, it should be understood that the descriptions of the present disclosure can be implemented in various other forms, and are not intended to be limited to the exemplary embodiments of the present disclosure. Also, in the drawings, descriptions of parts unrelated to the detailed description will be omitted to clearly describe one aspect of the present disclosure. Throughout the specification, like numbers refer to like elements.

Throughout the specification, when a certain element is referred to as being "connected to another element, it can be directly connected to the other element or indirectly connected to the other element with one or more intervening elements interposed therebetween. In addition, when an element is referred to as "including" another element, it should be understood that the element may further include still another element rather than excluding the still another element unless particularly indicated otherwise.

When a range of numerical values is presented in the present disclosure, the value has the precision of significant digits provided in accordance with the standard rules in chemistry for significant digits unless a specific range is stated otherwise. For example, the numerical value 10 includes the range of 5.0 to 14.9 and the numerical value 10.0 includes the range of 9.50 to 10.49.

Hereinafter, one embodiment of the present disclosure will be described in detail with reference to the accompanying drawings.

### Method of preparing a catalyst for manufacturing carbon nanotubes

A method of preparing a catalyst for manufacturing carbon nanotubes according to one aspect of the present disclosure includes: (a) dissolving a metal precursor in a solvent to prepare a precursor solution; (b) thermally decomposing the precursor solution by spraying the precursor solution into a reactor; and (c) obtaining a catalyst, wherein the catalyst includes a metal component represented by the following Chemical Formula 1:

[Chemical Formula 1] Coₓ:[M1, Zr]_{y}:M2_{z}

wherein Co may represent cobalt or oxides or derivatives thereof. The Co may serve as a main catalyst in the catalyst for manufacturing carbon nanotubes. When carbon nanotubes are synthesized using the catalyst, the carbon nanotubes may be grown into a structure with relatively excellent dispersibility.

In the above chemical formula, M1 may represent at least one metal, or oxides or derivatives thereof, selected from Al, Ca, Si, Ti, and Mg, and Zr may represent zirconium or oxides or derivatives thereof.

[M1, Zr] is an inert support that may support the main catalyst and cocatalyst components. [M1, Zr] indicates that M1 and Zr are contained in the same or different moles. For example, M1 may be contained in a mole number that is 1.5-, 2-, 2.5-, or 3-fold or more the mole number of Zr, but the present disclosure is not limited thereto.

The crystal structure of the catalyst is formed depending on the main catalyst, the cocatalyst, the composition of the inert support, and the ratio between components, and the growth pattern and properties of carbon nanotubes may vary accordingly. For example, it is possible to achieve electrical conductivity applicable as a conductive material when the carbon nanotubes are synthesized using a catalyst containing M1 and Zr as the inert support, and to achieve levels of dispersibility required for application to electrodes.

In the above chemical formula, M2 may be at least one metal, or oxides or derivatives thereof, selected from W, V, Mn, and Mo. The M2 may act as a cocatalyst which is an active ingredient that assists the action of the main catalyst in the catalyst for manufacturing carbon nanotubes. Synthesis efficiency may be improved while maintaining the structural characteristics of the carbon nanotubes as described above.

In the above chemical formula, x/y may satisfy 0.2 ≤ x/y ≤ 2.6. The "x/y" represents a mole fraction of the main catalyst relative to the support, and may, for example, be 0.2, 0.3, 0.4, 0.5, 0.6, 0.7, 0.8, 0.9, 1.0, 1.1, 1.2, 1.3, 1.4, 1.5, 1.6, 1.7, 1.8, 1.9, 2.0, 2.1, 2.2, 2.3, 2.4, 2.5, 2.6, or a value in a range between any two of these values. When the mole fraction (x/y) is less than the above range, the activity of the catalyst and the resulting synthesis yield of carbon nanotubes may be degraded, and the dispersibility of the manufactured carbon nanotubes may deteriorate, which makes the carbon nanotubes unsuitable as a conductive material for secondary batteries. When the mole fraction (x/y) is greater than the above range, the durability of the catalyst may deteriorate due to a relatively small content of the support. Also, because the synthesized carbon nanotubes exhibit an entangled structure, the BET specific surface area and powder resistance properties may deteriorate, and the dispersibility and electrical conductivity may be insufficient, which makes the carbon nanotubes unsuitable as a conductive material for secondary batteries.

In the above Chemical Formula, x/z may satisfy 6 ≤ x/z ≤ 13. The "x/z" represents a mole fraction of the main catalyst relative to the cocatalyst, and may, for example, be 6, 6.5, 7, 7.5, 8, 8.5, 9, 9.5, 10, 10.5, 11, 11.5, 12, 12.5, 13, or a value in a range between any two of these values. When the mole fraction (x/z) is less than the above range, the growth of carbon nanotubes may be hindered during reaction due to the excessive cocatalyst, resulting in a decreased amount of production, and the powder resistance of the manufactured carbon nanotubes may deteriorate, which makes the carbon nanotubes unsuitable as a conductive material for secondary batteries. When the mole fraction (x/z) is greater than the above range, an amount of production may decrease as the growth activity of carbon nanotubes decreases during reaction due to the lack of cocatalyst, and the powder resistance of the synthesized carbon nanotubes may deteriorate, which makes the carbon nanotubes unsuitable as a conductive material for secondary batteries.

Step (a) is a process of preparing a precursor solution including precursors for metal components included in the catalyst for manufacturing carbon nanotubes and may include introducing the metal precursor to a solvent and then stirring the resulting mixture under a nitrogen atmosphere.

The metal precursor may be one selected from the group consisting of nitrates, sulfates, alkoxides, chlorides, acetates, and carbonates of each metal, and mixtures of two or more thereof, but the present disclosure is not limited thereto.

In step (a), the solvent may be a polar solvent, and water, methanol, ethanol, propanol, isopropanol, butanol, or a mixed solvent of two or more thereof may be used as the polar solvent. For example, deionized water may be used, but the present disclosure is not limited thereto. When deionized water is used as the solvent, impurities in the precursor solution may be minimized, thereby improving the purity of the finally prepared catalyst. Improving the purity of the catalyst may ultimately mean improving the purity of carbon nanotubes.

Step (a) may include: (a1) dissolving a Co precursor, a Zr precursor, and at least one metal precursor selected from Al, Ca, Si, Ti, and Mg in a solvent to prepare a first precursor solution; and (a2) introducing at least one metal precursor selected from W, V, Mn, and Mo to the first precursor solution to prepare a second precursor solution. The order of steps (a1) and (a2) is not limited.

Step (a1) is a process of dissolving a precursor of the main catalyst and a precursor of the support in a solvent. In this case, the first precursor solution may be an acidic solution, but the present disclosure is not limited thereto.

Step (a2) is a process of introducing a precursor of the cocatalyst. In this case, the precursor of the cocatalyst may be basic, but the present disclosure is not limited thereto.

In step (a2), the first precursor solution may have a temperature of less than 30°C. For example, the temperature of the first precursor solution may be 29.9°C, 29.5°C, 29°C, 28.5°C, 28°C, 27.5°C, 27°C, 26.5°C, 26°C, 25.5°C, 25°C, 24.5°C, 24°C, 23.5°C, 23°C, 22.5°C, 22°C, 21.5°C, 21°C, 20.5°C, 20°C, or a value in a range between any two of these values, or may be less than 20°C. When the temperature of the first precursor solution is 30°C or higher, side reactions due to heat may proceed, resulting in a precipitation phenomenon. Therefore, the productivity and quality uniformity of the catalyst may deteriorate.

Step (a2) may include: introducing the metal precursor, and then stirring the resulting mixture under a nitrogen atmosphere. After the metal precursor is introduced, when the mixture is stirred under an atmosphere other than nitrogen, for example, an ambient atmosphere, a precipitation phenomenon may occur due to the reaction between the acidic first precursor solution and the basic cocatalyst precursor, which may result in deteriorated productivity and quality uniformity of the catalyst.

Step (b) may include: (b 1) spraying the precursor solution into the reactor with air at 1 to 3 bar; and (b2) thermally decomposing the sprayed precursor solution at 600 to 1,000°C.

In step (b1), the precursor solution may be sprayed into the reactor and converted into finer droplets in order to control the particle size, bulk density, and the like of the catalyst. When spraying the precursor solution, the pressure may be adjusted within the range of 1 to 3 bar. When the spray pressure is less than 1 bar, the particle size, bulk density, and the like of the catalyst may not be adjusted within a certain range, which may result in degraded purity of the carbon nanotubes synthesized through this process. When the spray pressure is greater than 3 bar, the particle size of the droplets may become excessively small, thereby causing the obtained catalyst to aggregate with each other.

In step (b2), the catalyst may be prepared by heating the droplets to evaporate the solvent and decompose the precursor. In this case, the temperature of the reactor may be 600 to 1,000°C. For example, the temperature of the reactor may be 600°C, 650°C, 700°C, 750°C, 800°C, 850°C, 900°C, 950°C, 1,000°C, or a value in a range between any two of these values. When the temperature of the reactor is less than the above range, the catalyst may be in a poorly dried state, and thus an additional process may be required, which is disadvantageous in terms of economic efficiency. Therefore, the purity or physical properties of the carbon nanotubes manufactured through this process may deteriorate. When the temperature of the reactor is greater than the above range, excessive costs are required to build equipment or facilities, resulting in economic loss and degraded performance of the catalyst due to formation of a solid solution or modification of a crystal structure.

In the above chemical formula, x/y may satisfy 0.5 ≤ x/y ≤ 2.0, and x/z may satisfy 8 ≤ x/z ≤ 9, but the present disclosure is not limited thereto. When the catalyst is a catalyst containing four component elements, it may be easier to control process conditions for manufacturing the desired carbon nanotubes when the ratio between respective components satisfies the above ranges, but the present disclosure is not limited thereto.

Step (c) is a process of finally obtaining the prepared catalyst for manufacturing carbon nanotubes. In this case, the catalyst may be obtained in a powder form, but the present disclosure is not limited thereto.

The catalyst for manufacturing carbon nanotubes prepared according to the method may be used in a chemical vapor deposition method to synthesize carbon nanotubes. For example, a fluidized-bed chemical vapor deposition method or a fixed-bed chemical vapor deposition method may be used, but the present disclosure is not limited thereto.

The catalyst for manufacturing carbon nanotubes prepared according to the method may be applied to the manufacture of carbon nanotubes having excellent electrical conductivity and dispersibility.

### Method of manufacturing carbon nanotubes

A method of manufacturing carbon nanotubes according to another aspect of the present disclosure includes: (1) introducing the catalyst for manufacturing carbon nanotubes prepared according to the method into a chemical vapor deposition reactor; and (2) spraying a carbon-based gas and a carrier gas to synthesize carbon nanotubes.

The chemical vapor deposition reactor may be a fluidized-bed chemical vapor deposition reactor, but the present disclosure is not limited thereto. Unlike conventional catalysts that may be used only in a fixed-bed chemical vapor deposition reactor due to problems such as the bulk density, the shape and strength of the catalyst, and the like, the catalyst may be used in both the fixed-bed chemical vapor deposition reactor and the fluidized-bed chemical vapor deposition reactor.

Although relatively diverse catalysts may be used in the fixed-bed chemical vapor deposition reactor, the productivity and uniformity of the synthesized carbon nanotubes may be insufficient. The fluidized-bed chemical vapor deposition reactor is advantageous for mass production and uniform manufacture of carbon nanotubes, but the types of catalysts that may be used may be limited.

The chemical vapor deposition reactor may have an internal temperature of 600 to 1,000°C. For example, the internal temperature of the chemical vapor deposition reactor may be 600°C, 650°C, 700°C, 750°C, 800°C, 850°C, 900°C, 950°C, 1,000°C, or a value in a range between any two of these values. When the temperature of the reactor is excessively low, the growth of carbon nanotubes may be impossible or delayed. When the temperature of the reactor is excessively high, the synthesized carbon nanotubes may be thermally decomposed or may not maintain their shape because they are bonded to each other.

The carbon-based gas may be one selected from the group consisting of saturated or unsaturated hydrocarbons having 1 to 4 carbon atoms, carbon monoxide, benzene, and a mixture of two or more thereof. For example, the carbon-based gas may be ethylene, propylene, acetylene, or methane, but the present disclosure is not limited thereto.

The carrier gas may be one selected from the group consisting of helium, nitrogen, argon, and a mixture of two or more thereof, but the present disclosure is not limited thereto.

In step (2), after the carbon-based gas decomposed by high-temperature heat is saturated as the carbon-based gas penetrates into the catalyst composition, the growth of the carbon nanotubes may be carried out while precipitating carbon, but the present disclosure is not limited thereto.

According to the above manufacturing method, a large amount of carbon nanotubes for secondary battery conductive materials may be effectively manufactured.

The carbon nanotubes manufactured according to the method may be an aggregate of carbon nanotubes grown on the catalyst. The carbon nanotube aggregate may be understood as a concept that includes both the catalyst composition and the carbon nanotubes. The carbon nanotube aggregate includes carbon nanotubes grown from the catalyst seed as described above. Because the growth pattern, purity, and the like of carbon nanotubes are determined depending on the type of catalyst, the electrical conductivity, dispersibility, solubility, and the like of the carbon nanotubes may vary when applied as a conductive material. Therefore, even when the diameter, length, purity, and the like of carbon nanotubes are similar, physical properties such as dispersibility, solubility, electrical conductivity, and the like may vary when the carbon nanotubes are manufactured using catalysts with different compositions.

In one example, in the carbon nanotube aggregate, each of the carbon nanotubes may be present in a straight shape, a curved shape, or a mixture thereof. Each of the carbon nanotubes may be a single-walled, double-walled, or multi-walled carbon nanotube.

In one example, the carbon nanotube aggregate may include bundle-type carbon nanotubes in which a plurality of carbon nanotubes are aggregated together. Each of the bundle-type carbon nanotubes may be present in a straight shape, a curved shape, or a mixture thereof.

In one example, the carbon nanotube aggregate may include multi-walled carbon nanotubes with an average number of walls ranging from 3 to 20. The carbon nanotube aggregate may implement the necessary physical properties as a conductive material for secondary batteries while using multi-walled carbon nanotubes, which are known to have relatively low conductivity compared to single-walled carbon nanotubes.

The carbon nanotubes manufactured according to the method may have a purity of 90 % or more. For example, the purity of the carbon nanotubes may be 90 %, 91 %, 92 %, 93 %, 94 %, 95 %, 96 %, 97 %, 98 %, or 99 % or more, but the present disclosure is not limited thereto. When the purity is outside the above range, electrical conductivity may be insufficient, or impurities may react inside the battery, resulting in safety accidents.

The carbon nanotube aggregate manufactured according to the method may have a BET specific surface area of 130 to 260 m²/g. For example, the BET specific surface area of the carbon nanotube aggregate may be 130 m²/g, 140 m²/g, 150 m²/g, 160 m²/g, 170 m²/g, 180 m²/g, 190 m²/g, 200 m²/g, 210 m²/g, 220 m²/g, 230 m²/g, 240 m²/g, 250 m²/g, 260 m²/g, or a value in a range between any two of these values. When the BET specific surface area is less than the above range, electrical conductivity may deteriorate, which makes the carbon nanotubes unsuitable as a conductive material for secondary batteries. On the other hand, when the BET specific surface area is greater than the above range, dispersibility may deteriorate.

The carbon nanotube aggregate manufactured according to the method may have a bulk density of 0.005 to 0.10 g/mL. For example, the bulk density of the carbon nanotube aggregate may be 0.005 g/mL, 0.01 g/mL, 0.02 g/mL, 0.03 g/mL, 0.04 g/mL, 0.05 g/mL, 0.06 g/mL, 0.07 g/mL, 0.08 g/mL, 0.09 g/mL, 0.10 g/mL, or a value in a range between any two of these values. The bulk density may be measured using carbon nanotubes in a powder form. When the bulk density is outside the above range, problems with excessive scattering of carbon nanotubes may occur, or dispersibility and solubility may be insufficient during the preparation of a conductive material slurry.

The carbon nanotubes manufactured according to the method may have an average fiber diameter of 3 to 30 nm. For example, the average fiber diameter of the carbon nanotubes may be 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, 21 nm, 22 nm, 23 nm, 24 nm, 25 nm, 26 nm, 27 nm, 28 nm, 29 nm, 30 nm, or a value in a range between any two of these values. When the average fiber diameter is outside the above range, the synthesized carbon nanotubes may have structural problems, or the desired properties of carbon nanotubes may be insufficient.

The carbon nanotubes manufactured according to the method may have an average powder resistance of 0.005 to 0.045 Ω·cm. For example, the average powder resistance of the carbon nanotube aggregate may be 0.005 Ω·cm, 0.006 Ω·cm, 0.007 Ω·cm, 0.008 Ω·cm, 0.009 Ω·cm, 0.01 Ω·cm, 0.011 Ω·cm, 0.012 Ω·cm, 0.013 Ω·cm, 0.014 Ω·cm, 0.015 Ω·cm, 0.016 Ω·cm, 0.017 Ω·cm, 0.018 Ω·cm, 0.019 Ω·cm, 0.02 Ω·cm, 0.021 Ω·cm, 0.022 Ω·cm, 0.023 Ω·cm, 0.024 Ω·cm, 0.025 Ω·cm, 0.026 Ω·cm, 0.027 Ω·cm, 0.028 Ω·cm, 0.029 Ω·cm, 0.03 Ω·cm, 0.031 Ω·cm, 0.032 Ω·cm, 0.033 Ω·cm, 0.034 Ω·cm, 0.035 Ω·cm, 0.036 Ω·cm, 0.037 Ω·cm, 0.038 Ω·cm, 0.039 Ω·cm, 0.04 Ω·cm, 0.041 Ω·cm, 0.042 Ω·cm, 0.043 Ω·cm, 0.044 Ω·cm, 0.045 Ω·cm, or a value in a range between any two of these values. When the powder resistance is greater than the above range, electrical conductivity may deteriorate, which makes the carbon nanotubes unsuitable as a conductive material for secondary batteries. Among the methods for analyzing the structure of carbon nanotubes, Raman spectroscopy, which is used to analyze the surface state of carbon nanotubes, may be usefully used. As used in the present disclosure, the term "Raman spectroscopy" refers to a method of calculating the frequency of molecules from the Raman effect, which is a phenomenon in which scattered light with a difference in frequency equal to the molecular frequency is generated when exposed to monochromatic excitation light such as laser light. Through such Raman spectroscopy, the crystallinity of carbon nanotubes may be measured in a quantifiable manner.

The peak that is present in a wavenumber region of 1,580 ± 50 cm⁻¹ in the Raman spectrum of the carbon nanotubes is referred to as a G band, which is a peak representing an sp² bond in the carbon nanotubes, and may represent a carbon crystal without structural defects. Also, the peak that is present in a wavenumber region of 1,360 ± 50 cm⁻¹ is referred to as a D band, which is a peak representing an sp³ bond of carbon nanotubes, and may represent carbon containing structural defects.

In addition, the peak values of the G band and D band are referred to as I_{G} and I_{D}, respectively, and the crystallinity of the carbon nanotubes may be measured in a quantifiable manner through the Raman spectral intensity ratio (I_{G}/I_{D}), which is a ratio between the G band and the D band. In other words, a higher Raman spectral intensity ratio means fewer structural defects in the carbon nanotubes. Therefore, when carbon nanotubes having a high Raman spectral intensity ratio are used, better electrical conductivity may be achieved.

The carbon nanotubes manufactured according to the method may have an Raman spectral intensity ratio (I_{G}/I_{D}) of 0.5 to 2.0. For example, the Raman spectral intensity ratio (I_{G}/I_{D}) of the carbon nanotubes may be 0.5, 0.6, 0.7, 0.8, 0.9, 1.0, 1.1, 1.2, 1.3, 1.4, 1.5, 1.6, 1.7, 1.8, 1.9, 2.0, or a value in a range between any two of these values. When the Raman spectral intensity ratio is outside the above range, the dispersibility of carbon nanotubes may deteriorate, which may make it difficult to achieve uniform conductivity when applied to electrodes.

The carbon nanotubes manufactured according to the method may have a surface resistance of 100 to 250 Ω/sq. For example, the surface resistance of the carbon nanotubes may be 100 Ω/sq, 110 Ω/sq, 120 Ω/sq, 130 Ω/sq, 140 Ω/sq, 150 Ω/sq, 160 Ω/sq, 170 Ω/sq, 180 Ω/sq, 190 Ω/sq, 200 Ω/sq, 210 Ω/sq, 220 Ω/sq, 230 Ω/sq, 240 Ω/sq, 250 Ω/sq, or a value in a range between any two of these values. When the surface resistance is greater than the above range, electrical conductivity may deteriorate, which makes the carbon nanotubes unsuitable as a conductive material for secondary batteries.

Because the carbon nanotubes manufactured according to the method have excellent physical properties including electrical conductivity and dispersibility, the capacity and lifespan characteristics of secondary batteries may be improved when the carbon nanotubes are used as a conductive material for secondary batteries. Therefore, the carbon nanotubes may be applied to the production of high-capacity secondary batteries with high energy density and a low self-discharge rate.

Unlike conventional carbon nanotubes, which are difficult to apply as a conductive material due to poor solubility when preparing electrode material slurries, and the like, the carbon nanotube aggregate is easily used to prepare slurries and may have excellent dispersibility. The conductive material for secondary batteries may prevent safety accidents that occur when current is concentrated locally.

The carbon nanotubes manufactured according to the method have superior powder resistance compared to carbon black, which is used as a conventional conductive material for secondary batteries, and may increase energy density even when it is used in a small amount, thereby improving the charging speed and efficiency of secondary batteries. Also, when the conductive material for secondary batteries is used, it may have sufficient current characteristics while containing a relatively large amount of an electrode material.

### [Mode for Invention]

Hereinafter, exemplary embodiments of the present disclosure will be described in more detail. However, it should be understood that the following experimental results describe only representative experimental results in the above embodiments, and the scope and content of the present disclosure should not be interpreted as being reduced or limited by the embodiments. Each effect of various implementations of the present disclosure that are not explicitly presented below will be described in detail in the corresponding sections.

### Examples 1 to 6 and Comparative Examples 1 to 4

Co(NO₃)₃·6H₂O, Al(NO₃)₃·9H₂O, ZrO(NO₃)₂·2H₂O, and deionized water was added to a reactor and then stirred under a nitrogen atmosphere to prepare a first precursor solution. NH₄VO₃ was added to the first precursor solution maintained at a temperature of less than 30°C and stirred under a nitrogen atmosphere to prepare a second precursor solution. At this time, each precursor was added in a desired amount according to the catalyst composition in Table 1 below. A catalyst composition was obtained by spraying the second precursor solution into a spray pyrolysis reactor with air at a rate of 3 L/hr and thermally decomposing the second precursor solution. The spray pressure of air was set at 1 to 3 bar, and the internal temperature of the spray pyrolysis reactor was set at 750°C.

**[Table 1]**

| Classification | Co (moles) | Al (moles) | Zr (moles) | V (moles) | Co/(Al+Zr) (mole fraction) | Co/V (mole fraction) |
|---|---|---|---|---|---|---|
| Example 1 | 6.59 | 3.20 | 0.83 | 0.76 | 1.64 | 8.67 |
| Example 2 | 6.09 | 3.80 | 1.12 | 0.7 | 1.24 | 8.70 |
| Example 3 | 5.76 | 4.20 | 1.24 | 0.67 | 1.06 | 8.60 |
| Example 4 | 5.36 | 4.68 | 1.38 | 0.62 | 0.88 | 8.65 |
| Example 5 | 4.85 | 5.29 | 1.57 | 0.56 | 0.71 | 8.66 |
| Example 6 | 4.18 | 6.09 | 1.80 | 0.48 | 0.53 | 8.71 |
| Comparative Example 1 | 7.70 | 1.87 | 0.55 | 0.89 | 3.18 | 8.65 |
| Comparative Example 2 | 2.00 | 8.72 | 2.58 | 0.23 | 0.18 | 8.70 |
| Comparative Example 3 | 4.52 | 4.94 | 1.46 | 1.31 | 0.71 | 3.45 |
| Comparative Example 4 | 4.97 | 5.42 | 1.60 | 0.29 | 0.71 | 17.14 |

### Comparative Example 5

A catalyst composition was prepared using the same composition and method as in Example 1, except that the temperature of the first precursor solution was maintained at 50°C.

### Comparative Example 6

A catalyst composition was prepared using the same composition and method as in Example 1, except that NH₄VO₃ was added to the first precursor solution and stirred under air.

### Manufacturing Example

Each of the catalyst compositions according to Examples and Comparative Examples was put into a fluidized-bed chemical vapor deposition reactor having a diameter of 350 mm, and the internal temperature of the reactor was raised to 700 to 800°C and maintained under a nitrogen atmosphere. Thereafter, carbon nanotubes were synthesized by reacting the resulting mixture for 50 minutes while supplying a mixed gas of nitrogen and ethylene at a rate of 150 L/min.

### Experimental Example 1

The structure, fiber diameter, and wall number of the carbon nanotubes synthesized according to the manufacturing example were determined through FE-SEM images, and the BET specific surface area and powder resistance were measured. The results are shown in Table 2 below. The BET specific surface area was measured using TriStar II 3020 equipment (Micromeritics). The powder resistance was measured by measuring the bulk density using HPRM-FA2 equipment (Hantech) and then calculating the volume resistance value when the density is 0.65 ± 0.01 g/mL using a trend line of volume resistivity (Ω·cm) according to the bulk density.

FIGS. 1 and 2 are FE-SEM images of the carbon nanotubes synthesized according to the manufacturing example using the catalyst compositions of Example 6 and Comparative Example 1, respectively.

**[Table 2]**

| Classification | Structure of carbon nanotubes | BET specific surface area (m²/g) | Powder resistance (Ω·cm) |
|---|---|---|---|
| Example 1 | Bundle | 152 | 0.035 |
| Example 2 | Bundle | 156 | 0.029 |
| Example 3 | Bundle | 162 | 0.026 |
| Example 4 | Bundle | 169 | 0.025 |
| Example 5 | Bundle | 187 | 0.026 |
| Example 6 | Bundle | 192 | 0.018 |
| Comparative Example 1 | Entangled | 105 | 0.046 |
| Comparative Example 2 | Bundle | 279 | 0.020 |
| Comparative Example 3 | Bundle | 193 | 0.047 |
| Comparative Example 4 | Bundle | 242 | 0.047 |

It was confirmed that the carbon nanotubes synthesized using the catalyst compositions of Examples 1 to 6 showed a bundle-shaped structure as shown in FIG. 1, and were applicable as a conductive material for secondary batteries because the carbon nanotubes had excellent BET specific surface area and powder resistance properties.

The carbon nanotubes synthesized using the catalyst composition of Comparative Example 1, which had a high Co/(Al+Zr) mole fraction of 3.18, exhibited an entangled structure as shown in FIG. 2, and the BET specific surface area and powder resistance properties deteriorated compared to those of Examples.

The carbon nanotubes synthesized using the catalyst composition of Comparative Example 2, which had a low Co/(Al+Zr) mole fraction of 0.18, exhibited excellent powder resistance because the carbon nanotubes had a very high BET specific surface area, but the dispersibility during dispersion preparation deteriorated due to the high BET specific surface area.

The carbon nanotubes synthesized using the catalyst composition of Comparative Example 3, which had a low Co/V mole fraction of 3.45, had a problem of hindered growth during reaction due to excess cocatalyst, which is an active ingredient, which resulted in decreased production, and the powder resistance of the synthesized carbon nanotubes deteriorated compared to those of Examples.

The carbon nanotubes synthesized using the catalyst composition of Comparative Example 4, which had a high Co/V mole fraction of 17.29, had decreased production as the growth activity of the carbon nanotubes decreased during reaction due to the lack of the cocatalyst, which is an active ingredient, and the powder resistance of the synthesized carbon nanotubes deteriorated compared to those of Examples.

### Experimental Example 2

To evaluate the electrical conductivity and dispersibility of the carbon nanotubes synthesized according to the manufacturing example, surface resistance measurement and dispersion evaluation of the carbon nanotubes were performed. The results are shown in Table 3 below.

The surface resistance of the carbon nanotubes was measured using a 4-point probe after bar coating. The evaluation of the dispersion of carbon nanotubes was conducted using bead mill equipment after the carbon nanotubes were added until the content of the carbon nanotubes reached 5% by weight in N-methylpyrrolidone (NMP). When the viscosity did not drop further during manufacturing using rotate ring mill (RRG) equipment, the dispersion evaluation was completed, and the manufacturing time was measured. When dispersion did not occur even after the carbon nanotubes were manufactured for 48 hours or more, the carbon nanotubes were evaluated as not being dispersed.

**[Table 3]**

| Classification | Surface resistance (Ω/sq) | Manufacturing time (hr) |
|---|---|---|
| Example 6 | 190 | 32 |
| Comparative Example 1 | 300 | 10 |
| Comparative Example 2 | - | Not dispersed |

It was confirmed that the carbon nanotubes synthesized using the catalyst composition of Example 6 had low surface resistance, excellent electrical conductivity and high dispersibility.

The carbon nanotubes synthesized using the catalyst composition of Comparative Example 1 had a short dispersion preparation time because the carbon nanotubes showed an entangled structure. However, because dispersion was not performed properly, electrical conductivity deteriorated compared to those of Examples.

The carbon nanotubes synthesized using the catalyst composition of Comparative Example 2 were not dispersed due to a very high BET specific surface area. As a result, the preparation of a 5% dispersion failed.

### Experimental Example 3

In Examples and Comparative Examples, a phenomenon of solution precipitation according to the method of preparing the second precursor solution was evaluated. The results are shown in Table 4 below.

**[Table 4]**

| Classification | Temperature of first precursor solution | Atmosphere for preparation of second precursor solution | Precipitation occurrence |
|---|---|---|---|
| Example 1 | Less than 30°C | Nitrogen | No |
| Comparative Example 5 | 50°C | Nitrogen | Yes |
| Comparative Example 6 | Less than 30°C | Air | Yes |

In the comparison between Example 1 and Comparative Example 5, when the temperature of the first precursor solution was 30°C or higher, side reactions due to heat proceeded, resulting in a precipitation phenomenon.

In the comparison between Example 1 and Comparative Example 6, it was confirmed that when the second precursor solution was prepared under a nitrogen atmosphere, it was possible to suppress a precipitation phenomenon that occurs during the reaction between the acidic first precursor solution and the basic NH₄VO₃ precursor solution.

It was confirmed that when the solution precipitation phenomenon occurred, the productivity and quality uniformity of the catalyst composition greatly deteriorated.

The description of the present disclosure described above is for illustrative purposes, and it should be understood that those of ordinary skill in the art to which one aspect of the present disclosure belongs can easily modify it into other specific forms without changing the technical idea or essential features described in this specification. Therefore, it should be understood that the embodiments described above are illustrative in all respects and not restrictive. For example, each component described as a single type may be implemented in a distributed form, and likewise, components described as distributed may be implemented in a combined form.

The scope of the present disclosure is defined by the appended claims, and all changes or modifications derived from the meaning and scope of the claims and their equivalents should be construed as being included in the scope of the present disclosure.

## Claims

1. A method of preparing a catalyst for manufacturing carbon nanotubes, comprising:
(a) dissolving a metal precursor in a solvent to prepare a precursor solution;
(b) thermally decomposing the precursor solution by spraying the precursor solution into a reactor; and
(c) obtaining a catalyst,
wherein the catalyst includes a metal component represented by the following Chemical Formula 1:
[Chemical Formula 1] Coₓ:[M1, Zr]_{y}:M2_{z}
wherein:
Co represents cobalt or oxides or derivatives thereof,
M1 represents at least one metal, or oxides or derivatives thereof, selected from Al, Ca, Si, Ti, and Mg,
Zr represents zirconium or oxides or derivatives thereof,
M2 represents at least one metal, or oxides or derivatives thereof, selected from W, V, Mn, and Mo,
x/y satisfies 0.2 ≤ x/y ≤ 2.6, and
x/z satisfies 6 ≤ x/z ≤ 13.

2. The method of claim 1, wherein step (a) includes:
(a1) dissolving a Co precursor, a Zr precursor, and at least one metal precursor selected from Al, Ca, Si, Ti, and Mg in a solvent to prepare a first precursor solution; and
(a2) introducing at least one metal precursor selected from W, V, Mn, and Mo to the first precursor solution to prepare a second precursor solution.

3. The method of claim 2, wherein, in step (a2), the first precursor solution has a temperature of less than 30°C.

4. The method of claim 2, wherein step (a2) includes: introducing the metal precursor and then stirring the resulting mixture under a nitrogen atmosphere.

5. The method of claim 1, wherein step (b) includes:
(b1) spraying the precursor solution into the reactor with air at 1 to 3 bar; and
(b2) thermally decomposing the sprayed precursor solution at 600 to 1,000°C.

6. The method of claim 1, wherein, in the chemical formula, x/y satisfies 0.5 ≤ x/y ≤ 2.0, and x/z satisfies 8 ≤ x/z ≤ 9.

7. A method of manufacturing carbon nanotubes, comprising:
(1) introducing the catalyst for manufacturing carbon nanotubes prepared according to claim 1 into a chemical vapor deposition reactor; and
(2) spraying a carbon-based gas and a carrier gas to synthesize carbon nanotubes.

8. The method of claim 7, wherein the chemical vapor deposition reactor is a fluidized-bed chemical vapor deposition reactor.

9. The method of claim 7, wherein the chemical vapor deposition reactor has an internal temperature of 600 to 1,000°C.

10. The method of claim 7, wherein the carbon-based gas is one selected from the group consisting of saturated or unsaturated hydrocarbons having 1 to 4 carbon atoms, carbon monoxide, benzene, and a mixture of two or more thereof.

11. The method of claim 7, wherein the carrier gas is one selected from the group consisting of helium, nitrogen, argon, and a mixture of two or more thereof.
